# EUROPÄISCHE PATENTSCHRIFT

(11) **EP 3 380 855 B1**
(45) Veröffentlichungstag und Bekanntmachung des Hinweises auf die Patenterteilung: **15.05.2019**
(21) Anmeldenummer: 17700510.5
(22) Anmeldetag: 12.01.2017
(51) Int. Cl.: G01R 31/36

(54) **VERFAHREN ZUR ERMITTLUNG EINER LEISTUNGSFÄHIGKEITSINFORMATION EINER BATTERIE EINES KRAFTFAHRZEUGSEITIGEN, AN EINEN GLEICHSPANNUNGSWANDLER ANGEBUNDENEN BORDNETZES UND KRAFTFAHRZEUG**
METHOD FOR DETERMINING PERFORMANCE INFORMATION OF A BATTERY OF A MOTOR VEHICLE ON-BOARD POWER SYSTEM THAT IS CONNECTED TO A DIRECT CURRENT CONVERTER, AND MOTOR VEHICLE
PROCÉDÉ DE DÉTERMINATION D'UNE INFORMATION DE CAPACITÉ D'UNE BATTERIE D'UN RÉSEAU DE BORD EMBARQUÉ DANS UN VÉHICULE À MOTEUR ET RELIÉ À UN CONVERTISSEUR CC-CC, ET VÉHICULE À MOTEUR

(30) Priorität: 22.01.2016 DE 102016000668
(43) Veröffentlichungstag der Anmeldung: 03.10.2018
(73) Patentinhaber: AUDI AG, 85045 Ingolstadt (DE)
(72) Erfinder: HACKNER, Thomas, 91171 Greding (DE); NAUMANN, Rolf, 96247 Michelau (DE)
(86) Internationale Anmeldenummer: PCT/EP2017/050559
(87) Internationale Veröffentlichungsnummer: WO 2017/125310

(56) Entgegenhaltungen:
- DE-A1-102012 215 755
- DE-A1-102013 211 742
- DE-B3-102014 004 791
- JP-A- 2005 332 702
- US-A1- 2015 008 929

## Beschreibung

Die Erfindung betrifft ein Verfahren zur Ermittlung einer Leistungsfähigkeitsinformation einer Batterie eines kraftfahrzeugseitigen, an einen Gleichspannungswandler angebundenen Bordnetzes. Daneben betrifft die Erfindung ein Kraftfahrzeug.

Zur Gewährleistung einer ordnungsgemäßen Funktionalität des Bordnetzes eines Kraftfahrzeugs ist die Ermittlung der die Batterie des Bordnetzes betreffenden Leistungsfähigkeitsinformation von großer Wichtigkeit, um die Batterie mit einer optimalen Lade- und Entladestrategie zu betreiben. Bei herkömmlichen Kraftfahrzeugen mit lediglich einem einzigen, typischerweise eine Bleibatterie mit einer Nennspannung von 12 Volt aufweisenden Bordnetz ist es bekannt, die Leistungsfähigkeitsinformation durch eine Messung eines Batteriestroms, einer Batteriespannung und einer Batterietemperatur zu ermitteln. Da derartige Bordnetze mittels eines eine Stromwelligkeit im Bordnetz erzeugenden Klauenpolgenerators gespeist werden, kann zudem die Anregung der Batterie durch diese Stromwelligkeit für eine Ermittlung der Leistungsfähigkeitsinformation genutzt werden.

Diese Möglichkeit der Ermittlung der Leistungsfähigkeitsinformation ist jedoch nicht deterministisch und insbesondere abhängig von der Leistungsaufnahme und -abgabe des Klauenpolgenerators sowie der Verbraucher und der Verkabelung des Bordnetzes. Bei elektrisch betriebenen und/oder mehrere über einen Gleichspannungswandler gekoppelte Bordnetze aufweisenden Kraftfahrzeugen fehlt mitunter auch der Klauenpolgenerator im Bordnetz, da die Batterie dynamisch durch den Gleichspannungswandler versorgt wird.

Eine Stromwelligkeit, die zur Ermittlung der Leistungsfähigkeitsinformation verwendet werden kann, ist in solchen Bordnetzen mithin nicht gegeben.

Aus der DE 10 2014 007 016 A1 ist ein Verfahren zur Ermittlung einer den Ladezustand und/oder die Leistungsfähigkeit einer ersten elektrischen Energiespeichereinrichtung beschreibenden Zustandsinformation bekannt, wobei die erste elektrische Energiespeichereinrichtung mit einer zweiten elektrischen Energiespeichereinrichtung in Reihe geschaltet ist. Dabei wird eine definierte elektrische Energiemenge aus der zweiten Energiespeichereinrichtung in die erste Energiespeichereinrichtung eingebracht, wonach in Abhängigkeit der eingebrachten elektrischen Energiemenge ein veränderlicher Zustandsparameter der ersten Energiespeichereinrichtung und die Zustandsinformation anhand des Zustandsparameters ermittelt werden.

Die DE 10 2013 219 293 A1 offenbart ein Fahrzeug mit einem Hochvoltbordnetz, einem Niedervoltbordnetz, einem Gleichstromsteller zwischen den beiden Bordnetzen und einem Niedervoltenergiespeicher im Niedervoltbordnetz sowie einem Hochvoltenergiespeicher im Hochvoltbordnetz. Dabei ist vorgesehen, dass in einer Standphase des Fahrzeugs durch den Gleichstromsteller der Niedervoltenergiespeicher mit einem vorgebbaren Strompuls belastbar und mit einem dem Niedervoltenergiespeicher zugeordneten Batteriesensor die Stromantwort auf den Strompuls messbar ist.

Weitere Vorrichtungen sind aus DE 10 2012 215755 A1, US 2015/008929, und DE 10 2013 211742 A1 bekannt.

Der Erfindung liegt mithin die Aufgabe zugrunde, eine demgegenüber zuverlässigere Möglichkeit zur Ermittlung der Leistungsfähigkeitsinformation bei einem an einen Gleichspannungswandler angebundenen Bordnetz anzugeben.

Zur Lösung dieser Aufgabe wird erfindungsgemäß ein Verfahren zur Ermittlung einer Leistungsfähigkeitsinformation einer Batterie eines kraftfahrzeugseitigen, an einen Gleichspannungswandler angebundenen Bordnetzes vorgeschlagen, wobei der Gleichspannungswandler zum Einprägen wenigstens eines wenigstens eine vorgegebene Frequenz aufweisenden Wechselstroms in das Bordnetz angesteuert wird und aus wenigstens einer ersten elektrischen Größe an einem bordnetzseitigen Ausgang des Gleichspannungswandlers und wenigstens einer die Reaktion der Batterie auf den eingeprägten Wechselstrom beschreibenden zweiten elektrischen Größe die Leistungsfähigkeitsinformation abgeleitet wird.

Die Erfindung beruht auf der Überlegung, den das Bordnetz speisenden Gleichspannungswandler gezielt zur Erzeugung eines einen Wechselanteil aufweisenden Ausgangssignals an seinem bordnetzseitigen Ausgang anzusteuern und aus der Reaktion der Batterie einen Rückschluss auf deren Leistungsfähigkeit zu ziehen. Dadurch wird die bei herkömmlichen Verfahren durch den Klauenpolgenerator erzeugte, jedoch nicht vorgebbare Stromwelligkeit durch den wenigstens einen deterministischen Wechselstrom ersetzt und in das Bordnetz eingeprägt. Selbstverständlich erzeugt der Gleichspannungswandler dabei an seinem Ausgang auch einen Gleichanteil, der betragsmäßig wesentlich größer als die Effektivspannung des wenigstens einen Wechselstroms ist. Der Strom und/oder die Spannung am bordnetzseitigen Ausgang des Gleichspannungswandlers ist einstellbar, so dass durch diesen mittels gezielter Variation dieses Stroms und/oder dieser Spannung das Ausgangsignal mit dem wenigstens einen Wechselstrom bzw. Wechselanteil erzeugbar ist.

Im Rahmen des erfindungsgemäßen Verfahrens beschreibt die erste elektrische Größe am bordnetzseitigen Ausgang des Gleichspannungswandlers die elektrischen Eigenschaften des wenigstens einen Wechselstroms, wobei diese erste elektrische Größe gemessen werden kann oder aus den die Ansteuerung des Gleichspannungswandlers bewirkenden Steuerdaten ohnehin vorliegt. Die wenigstens eine zweite elektrische Größe wird hingegen an der Batterie erfasst, insbesondere gemessen, wozu zweckmäßigerweise Messdaten eines der Batterie zugeordneten Batteriesteuergeräts verwendet werden. Bei der Batterie handelt es sich bevorzugt um eine Bleibatterie mit einer Nennspannung von 12 Volt oder 24 Volt.

Die Leistungsfähigkeitsinformation beschreibt insbesondere einen Ladezustand (State of Charge - SOC) und/oder einen Gesundheitszustand (State of Health - SOH) der Batterie. Diese lassen sich - wie aus dem Stand der Technik grundsätzlich bekannt - aus der durch die zweite elektrische Größe beschriebenen Reaktion auf die Anregung der Batterie mit dem durch die erste elektrische Größe beschriebenen wenigstens einen Wechselstrom ableiten. Bevorzugt wird zur Durchführung des erfindungsgemäßen Verfahrens ein dem Bordnetz zugeordnetes Steuergerät, insbesondere ein Energiemanagementsteuergerät, verwendet, welches zur Kommunikation mit dem Batteriesteuergerät und dem Gleichspannungswandler ausgebildet ist.

Mit Vorteil kann so eine von Störgrößen wie dem Betriebsverhalten von Verbrauchern des Bordnetzes, und der Topologie der Verkabelung des Bordnetzes weitestgehend unabhängige und mithin deterministische Ermittlung der Leistungsfähigkeitsinformation erfolgen. Gegenüber herkömmlichen Verfahren, bei denen die Reaktion der Batterie auf einen sprungartigen Stromanstieg, der während der Startphase des Kraftfahrzeugs auftritt, ermittelt wird, kann das erfindungsgemäße Verfahren ferner auch zu beliebigen Zeitpunkten während des Betriebs des Kraftfahrzeugs durchgeführt werden. Insbesondere ist die erste elektrische Größe wesentlich genauer bekannt als die Stromwelligkeit des Klauenpolgenerators bzw. das Schaltverhalten, insbesondere der Schaltzeitpunkt und die Flankensteilheit, eines Gleichspannungswandlers bei einem Strompuls. Es lässt sich mithin eine wesentlich zuverlässigere Ermittlung der Leistungsfähigkeitsinformation realisieren.

Bei dem erfindungsgemäßen Verfahren ist es zweckmäßig, wenn als erste elektrische Größe ein Strom am bordnetzseitigen Ausgang des Gleichspannungswandlers und/oder eine am bordnetzseitigen Ausgang des Gleichspannungswandlers anliegende Spannung erfasst wird. Dies kann einerseits durch Messen dieses Stroms bzw. dieser Spannung oder aber auch anhand von zur Ansteuerung des Gleichspannungswandlers verwendeten Steuerdaten, die im Steuergerät vorliegen, erfolgen. Alternativ oder zusätzlich kann als zweite elektrische Größe ein Strom und/oder eine Spannung in einem die wenigstens eine Frequenz umfassenden Messbereich an der Batterie gemessen werden. Bevorzugt werden dazu eine Strommesseinrichtung bzw. eine Spannungsmesseinrichtung verwendet, welche zweckmäßigerweise im Batteriesteuergerät integriert sind. Sowohl die wenigstens eine erste elektrische Größe als auch die wenigstens eine zweite elektrische Größe beschreiben bevorzugt den Strom bzw. die Spannungen als einen zeitlichen Verlauf und/oder als ein Frequenzspektrum.

Bei dem erfindungsgemäßen Verfahren wird ein Wechselstrom mit mehreren sich überlagernden unterschiedlichen Frequenzen verwendet. Diese Frequenzen sind zweckmäßigerweise so gewählt, dass ihre jeweils an der Batterie hervorgerufenen Reaktionen unterscheidbar anhand der wenigstens einen zweiten elektrischen Größe ausgewertet werden können. Alternativ können mehrere zeitlich nacheinander eingeprägte Wechselströme mit jeweils wenigstens einer Frequenz verwendet werden. Es sind mithin mehrere Zeitabschnitte definiert, an denen jeweils ein Wechselstrom mit einer oder mehreren Frequenzen in das Bordnetz eingeprägt wird, so dass für jeden Zeitabschnitt die wenigstens eine zweite elektrische Größe erfasst wird. Es lassen sich mithin unterschiedliche frequenzabhängige Reaktionen der Batterie erfassen und daraus Rückschlüsse auf die Leistungsfähigkeit der Batterie ziehen.

Im Rahmen des erfindungsgemäßen Verfahrens werden mittels der wenigstens einen ersten elektrischen Größe und der wenigstens einen zweiten elektrischen Größe mehrere Komponenten eines Ersatzschaltbildes der Batterie ermittelt, wobei die Leistungsfähigkeitsinformation aus Eigenschaften der mehreren Komponenten abgeleitet wird. Aus dem Stand der Technik ist eine Vielzahl von Ersatzschaltbildern für Batterien bekannt, die ihr Betriebsverhalten modellieren. Eigenschaften der Komponenten können beispielsweise Widerstands-, Kapazitäts- oder Induktivitätswerte entsprechender Wirk- bzw. Blindwiderstände sein. So ist beispielsweise das Ersatzschaltbild nach Randles bekannt, welches sich besonders zur Ableitung der Leistungsfähigkeitsinformation eignet. Es wird daher besonders bevorzugt, wenn ein einen Elektrolytwiderstand und/oder einen Ladungstransferwiderstand und/oder eine Warburg-Impedanz und/oder eine Doppelschichtkapazität als Komponenten umfassendes Ersatzschaltbild verwendet wird. Es wird bei der Ermittlung der Eigenschaften der Komponenten des Ersatzschaltbilds angeordnet, dass die Anzahl der verwendeten Frequenzen wenigstens der Anzahl der zu ermittelnden Komponenten entspricht.

Außerdem wird es bei dem erfindungsgemäßen Verfahren bevorzugt, wenn ein Gleichspannungswandler verwendet wird, welcher das Bordnetz mit einem weiteren Bordnetz koppelt. Bei diesem weiteren Bordnetz handelt es sich bevorzugt um ein Hochvoltbordnetz zur Versorgung eines Elektromotors des Kraftfahrzeugs oder ein Niedervoltbordnetz höherer Betriebsspannung als die Nennspannung der Batterie. Das Hochvoltbordnetz weist dabei insbesondere eine Nennspannung von wenigstens 60 Volt, bevorzugt wenigstens 300 Volt, auf. Bei dem Niedervoltbordnetz als weiteres Bordnetz wird bevorzugt eine Nennspannung von 48 Volt verwendet. Durch den Gleichspannungswandler ist somit ein Leistungstransport zwischen beiden Bordnetzen möglich ist. Insbesondere bei der Verwendung eines Hochvoltbordnetzes als weiteres Bordnetz kann so durch Rekuperation gewonnene elektrische Energie in das Bordnetz eingespeist werden.

Das erfindungsgemäße Verfahren kann grundsätzlich kontinuierlich während des Betriebs des Kraftfahrzeugs durchgeführt werden. Es wird jedoch bevorzugt, wenn das Verfahren auf Anforderung eines, insbesondere durch das Steuergerät realisierten, Energiemanagementsystems des Kraftfahrzeugs und/oder zyklisch und/oder bei einem Starten des Kraftfahrzeugs durchgeführt wird. Vorteilhafterweise kann die Ermittlung der Leistungsfähigkeitsinformation dadurch in einem breiten Spektrum von Betriebszuständen des Kraftfahrzeugs durchgeführt werden, so dass auch ihre Aktualisierung während des Betriebs des Kraftfahrzeugs flexibel möglich ist.

Daneben betrifft die Erfindung ein Kraftfahrzeug, umfassend eine Batterie eines an einen Gleichspannungswandler angebundenen Bordnetzes. Das erfindungsgemäße Kraftfahrzeug zeichnet sich dadurch aus, dass es zusätzlich ein zur Durchführung des erfindungsgemäßen Verfahrens ausgebildetes Steuergerät aufweist. Sämtliche Ausführungen zum erfindungsgemäßen Verfahren lassen sich analog auf das erfindungsgemäßen Kraftfahrzeug übertragen, so dass auch mit diesem die zuvor genannten Vorteile erzielt werden können.

Weitere Einzelheiten und Vorteile der Erfindung ergeben sich aus den im Nachfolgenden beschriebenen Ausführungsbeispielen sowie anhand der Zeichnungen. Diese sind schematische Darstellungen und zeigen:
- Fig. 1: eine Prinzipskizze eines Ausführungsbeispiels eines erfindungsgemäßen Kraftfahrzeugs und
- Fig. 2: ein Ersatzschaltbild zur Verwendung im Rahmen eines erfindungsgemäßen Verfahrens.

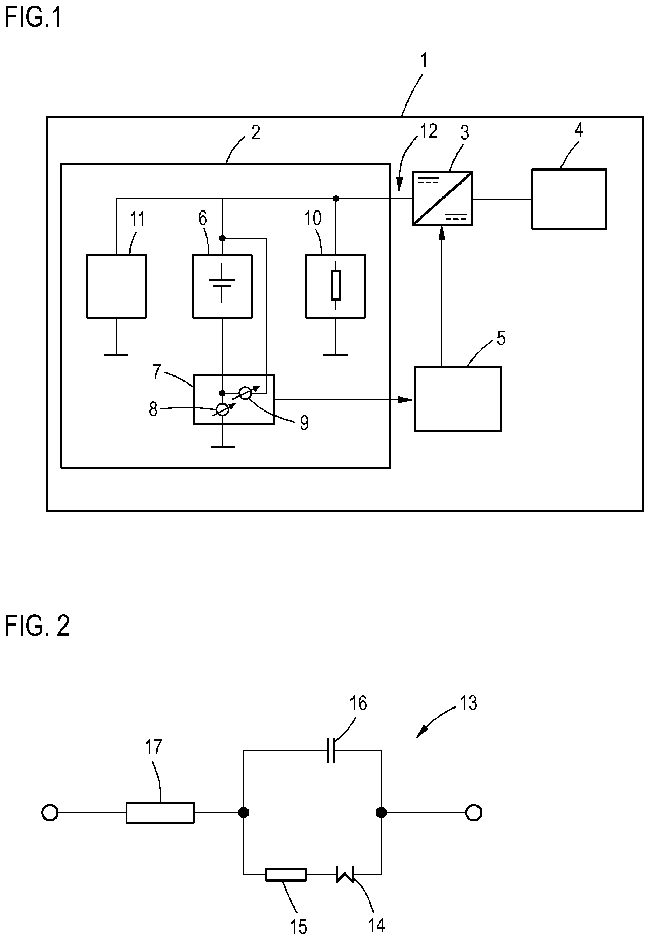

Fig. 1 zeigt eine Prinzipskizze eines Ausführungsbeispiels eines Kraftfahrzeugs 1, umfassend ein Bordnetz 2, das an ein Gleichspannungswandler 3 angebunden ist. Über diesen ist es Bordnetz 2 mit einem weiteren Bordnetz 4 gekoppelt. Daneben ist ein Steuergerät 5 vorgesehen, welche zur Ansteuerung des Gleichspannungswandlers 3 ausgebildet ist.

Das Bordnetz 2 umfasst eine Batterie 6 in Form einer Bleibatterie mit einer Nennspannung von 12 Volt, welcher ein Batteriesteuergerät 7 zugeordnet ist. Dieses weist eine Strommesseinrichtung 8 auf, welche den zeitlichen Verlauf und das Frequenzspektrum eines durch die Batterie 6 fließenden Stroms misst. Zusätzlich ist eine Spannungsmesseinrichtung 9 vorgesehen, welche den zeitlichen Verlauf und das Frequenzspektrum der an der Batterie 6 anliegenden Spannung misst. Das Bordnetz weist ferner mehrere lediglich schematisch dargestellte Verbraucher 10 auf.

Das weitere Bordnetz 4 ist ein Hochvoltbordnetz mit einer Nennspannung von 300 Volt, welches einen Elektromotor (nicht gezeigt) des elektrisch angetriebenen Kraftfahrzeugs 1 versorgt. Der Gleichspannungswandler 3 dient der Anpassung der unterschiedlichen Spannungslagen der Bordnetze 2, 4 und ist als bidirektionaler Gleichspannungswandler ausgebildet, so dass ein Leistungstransport vom Bordnetz 2 in das weitere Bordnetz 4 und umgekehrt möglich ist. So kann beispielsweise durch Rekuperation gewonnene elektrische Energie aus dem weiteren Bordnetz 4 in das Bordnetz 2 eingespeist werden. In einem weiteren Ausführungsbeispiel ist das weitere Bordnetz 4 ein Niedervoltbordnetz mit einer Nennspannung von 48 Volt, welches zur Versorgung spezieller auf diese Spannungslage ausgelegter Verbraucher ausgebildet ist. Dabei weist das Bordnetz 2 einen Startergenerator 11 zum Starten eines Verbrennungsmotors (nicht gezeigt) des Kraftfahrzeugs 1 auf.

Der Steuergerät 5 realisiert ein Energiemanagementsystem des Kraftfahrzeugs 1 und ist zur Durchführung eines im Folgenden beschriebenen Verfahrens zur Ermittlung einer Leistungsfähigkeitsinformation der Batterie 6 des kraftfahrzeugseitigen, an den Gleichspannungswandler 3 angebundenen Bordnetzes 2 ausgebildet:
Der Gleichspannungswandler 3 erzeugt eine Gleichspannung von 14 Volt zum Laden der Batterie 6. Der Steuergerät 5 steuert den Gleichspannungswandler 3 zudem zur Erzeugung eines Wechselstroms mit mehreren Frequenzen an, indem es seine Spannung am Ausgang 12 variiert. Eine Spannung und ein Strom am Ausgang 12 werden jeweils als erste elektrische Größe erfasst und beschreiben den zeitlichen Verlauf und das Frequenzspektrum des Ausgangssignals des Gleichspannungswandlers 3. Diese ersten elektrischen Größen sind aus den Ansteuerdaten des Steuergeräts 5 für den Gleichspannungswandler 3 bekannt bzw. können aus diesen ermittelt werden. In einem alternativen Ausführungsbeispiel werden die ersten elektrischen Größen über zusätzliche Spannung- und Strommesseinrichtungen (nicht gezeigt) am Ausgang 12 des Gleichspannungswandlers 3 gemessen.

Der eingeprägte Wechselstrom erzeugt an der Batterie 6 eine Reaktion, die durch mittels der Strommesseinrichtung 8 und der Spannungsmesseinrichtung 9 gemessener zweite elektrische Größen beschrieben wird. In Kenntnis der den zeitlichen Verlauf und das Frequenzspektrum des Stroms und der Spannung beschreibenden zweiten elektrischen Größen in Verbindung mit den die Reaktion anregenden ersten elektrischen Größen ermittelt das Steuergerät 5 die Eigenschaften eines Ersatzschaltbild nach Randles für die Batterie 6.

Fig. 2 zeigt das im Rahmen des Verfahrens verwendete Ersatzschaltbild 13. Dieses umfasst einen mit einer Warburg-Impedanz 14 in Reihe geschalteten Ladungstransferwiderstand 15, denen eine Doppelschichtkapazität 16 parallel geschaltet ist. In Reihe mit dieser Parallelschaltung befindet sich zudem ein Elektrolytwiderstand 17. Der vom Leistungswandler 3 erzeugte Wechselstrom umfasst zumindest so viele Frequenzen wie die Anzahl der Komponenten des Ersatzschaltbilds 13, so dass die Eigenschaften der Komponenten, also Resistanzwerte für den Ladungstransferwiderstand 15 und den Elektrolytwiderstand 17, ein Reaktanzwert für die Doppelschichtkapazität 16 und ein Warburg-Koeffizient für die Warburg-Impedanz 14, rechnerisch ermittelbar sind.

Aus diesen Eigenschaften leitet der Steuergerät 5 die einen Ladezustand (State of Charge - SOC) und einen Gesundheitszustand (State of Health - SOH) der Batterie 6 beschreibende Leistungsfähigkeitsinformation ab und verwendet sie bei der Ermittlung einer Lade- und Entladestrategie für die Batterie 6. Zudem ist die Leistungsfähigkeitsinformation im Wartungsfall vom Steuergerät 5 abrufbar und wird zur Ausgabe einer Warnung an den Fahrer des Kraftfahrzeugs 1 im Falle einer unzureichenden Leistungsfähigkeit der Batterie 6 ausgewertet.

Dass Verfahren wird beim Starten des Kraftfahrzeugs 1 und anschließend zyklisch sowie auf Anforderung des Steuergeräts 5 bei Bedarf durchgeführt. In alternativen Ausführungsbeispielen wird das Verfahren kontinuierlich durchgeführt.

In einem weiteren Ausführungsbeispiel des Verfahrens werden anstelle eines einzigen, mehrere Frequenzen aufweisenden Wechselstroms zeitlich nacheinander mehrere Wechselströme mit jeweils einer oder mehreren Frequenzen in das Bordnetz 2 eingeprägt. Die Ermittlung der Eigenschaften der Komponenten des Ersatzschaltbild 13 erfolgt dementsprechend nach Erfassung der zweiten elektrischen Größen für jeden der mehreren Wechselströme.

## Patentansprüche

1. Verfahren zur Ermittlung einer Leistungsfähigkeitsinformation einer Batterie (6) eines kraftfahrzeugseitigen, an einen Gleichspannungswandler (3) angebundenen Bordnetzes (2), wobei der Gleichspannungswandler (3) zum Einprägen wenigstens eines wenigstens eine vorgegebene Frequenz aufweisenden Wechselstroms in das Bordnetz (2) angesteuert und aus wenigstens einer ersten elektrischen Größe an einem bordnetzseitigen Ausgang (12) des Gleichspannungswandlers (3) und wenigstens einer die Reaktion der Batterie (6) auf den eingeprägten Wechselstrom beschreibenden zweiten elektrischen Größe die Leistungsfähigkeitsinformation abgeleitet wird, wobei ein Wechselstrom mit mehreren sich überlagernden unterschiedlichen Frequenzen oder mehrere zeitlich nacheinander eingeprägte Wechselströme mit jeweils wenigstens einer Frequenz verwendet werden, wobei mittels der wenigstens einen ersten elektrischen Größe und der wenigstens einen zweiten elektrischen Größe mehrere Komponenten eines Ersatzschaltbildes (13) der Batterie (6) ermittelt werden, wobei die Anzahl der verwendeten Frequenzen wenigstens die Anzahl der zu ermittelnden Komponenten beträgt und die Leistungsfähigkeitsinformation aus Eigenschaften der mehreren Komponenten abgeleitet wird.

2. Verfahren nach Anspruch 1,
**dadurch gekennzeichnet,**
**dass** als erste elektrische Größe ein Strom am bordnetzseitigen Ausgang (12) des Gleichspannungswandlers (3) und/oder eine am bordnetzseitigen Ausgang (12) des Gleichspannungswandlers (3) anliegende Spannung erfasst wird und/oder als zweite elektrische Größe ein Strom und/oder eine Spannung in einem die wenigstens eine Frequenz umfassenden Messbereich an der Batterie (6) gemessen wird.

3. Verfahren nach Anspruch 1 oder 2,
**dadurch gekennzeichnet,**
**dass** ein einen Elektrolytwiderstand (17) und/oder einen Ladungstransferwiderstand (15) und/oder eine Warburg-Impedanz und/oder eine Doppelschichtkapazität als Komponenten umfassendes Ersatzschaltbild verwendet wird.

4. Verfahren nach einem der vorhergehenden Ansprüche,
**dadurch gekennzeichnet,**
**dass** ein Gleichspannungswandler (3) verwendet wird, welcher das Bordnetz (2) mit einem weiteren Bordnetz (4), insbesondere einem Hochvoltbordnetz zur Versorgung eines Elektromotors des Kraftfahrzeugs (1) oder einem Niedervoltbordnetz höherer Betriebsspannung als eine Nennspannung der Batterie (6), koppelt.

5. Verfahren nach einem der vorhergehenden Ansprüche,
**dadurch gekennzeichnet,**
**dass** das Verfahren auf Anforderung eines Energiemanagementsystems des Kraftfahrzeugs (1) und/oder zyklisch und/oder bei einem Starten des Kraftfahrzeugs (1) durchgeführt wird.

6. Kraftfahrzeug (1), umfassend eine Batterie (6) eines an einen Gleichspannungswandler (3) angebunden Bordnetzes (2),
**dadurch gekennzeichnet,**
**dass** das Kraftfahrzeug (1) zusätzlich eine zur Durchführung eines Verfahrens nach einem der vorhergehenden Ansprüche ausgebildetes Steuergerät (5) aufweist.

## Claims

1. Method for determining performance information of a battery (6) of a motor vehicle-side on-board power system (2) that is connected to a direct current converter (3), wherein the direct current converter (3) is controlled to imprint into the on-board power system (2) at least one alternating current having at least one predetermined frequency, and the performance information is derived from at least one first electrical value at an on-board power system-side output (12) of the direct current converter (3) and at least one second electrical value describing the reaction of the battery (6) to the imprinted alternating current, wherein an alternating current having several different frequencies which overlap one another or several alternating currents imprinted chronologically after one another having in each case at least one frequency are used, wherein by means of the at least one first electrical value and the at least one second electrical value several components of an equivalent circuit diagram (13) of the battery (6) are determined, wherein the number of the used frequencies is at least the number of the components to be determined and the performance information is derived from properties of the several components.

2. Method according to claim 1,
**characterised in**
**that** as first electrical value a current at the on-board power system-side output (12) of the direct current converter (3) and/or a voltage applied at the on-board power system side output (12) of the direct current converter (3) is detected and/or as a second electrical value a current and/or a voltage in a measurement region, comprising the at least one frequency, at the battery (6) is measured.

3. Method according to claim 1 or 2,
**characterised in**
**that** an equivalent circuit diagram is used which includes an electrolyte resistance (17) and/or a load transfer resistance (15) and/or a Warburg-impedance and/or a double-layer capacity as components.

4. Method according to any of the preceding claims,
**characterised in**
**that** a direct current converter (3) is used which couples the on-board power system (2) with a further on-board power system (4), in particular a high-voltage on-board power system for the supply of an electric motor of the motor vehicle (1) or a low-voltage on-board power system with higher operational voltage than a nominal voltage of the battery (6).

5. Method according to any of the preceding claims,
**characterised in**
**that** the method is carried out when requested by an energy management system of the motor-vehicle (1) and/or cyclically and/or at a starting of the motor-vehicle (1).

6. Motor vehicle (1), including a battery (6) of an on-board power system (2) connected to a direct current converter (3),
**characterised in**
**that** the motor vehicle (1) has additionally a control device (5) configured to carry out a method according to any of the preceding claims.

## Revendications

1. Procédé de détermination d'une information de capacité d'une batterie (6) d'un réseau de bord (2) côté véhicule à moteur relié à un convertisseur CC-CC (3), dans lequel le convertisseur CC-CC (3) est commandé pour imprimer au moins un courant alternatif présentant au moins une fréquence prédéfinie dans le réseau de bord (2) et l'information de capacité est déduite à partir d'au moins une première grandeur électrique à une sortie (12) côté réseau de bord du convertisseur CC-CC (3) et d'au moins une deuxième grandeur électrique décrivant la réaction de la batterie (6) au courant alternatif imprimé, dans lequel un courant alternatif avec plusieurs fréquences différentes se chevauchant ou plusieurs courants alternatifs imprimés temporellement l'un après l'autre avec respectivement au moins une fréquence sont utilisés, dans lequel plusieurs composantes d'un schéma des connexions de remplacement (13) de la batterie (6) sont déterminées au moyen de l'au moins une première grandeur électrique et de l'au moins une deuxième grandeur électrique, dans lequel le nombre de fréquences utilisées est au moins le nombre des composantes à déterminer et l'information de capacité est déduite à partir de propriétés des plusieurs composantes.

2. Procédé selon la revendication 1,
**caractérisé en ce**
**qu'**un courant à la sortie (12) côté réseau de bord du convertisseur CC-CC (3) et/ou une tension appliquée à la sortie (12) côté réseau de bord du convertisseur CC-CC (3) est détecté en tant que première grandeur électrique et/ou un courant et/ou une tension est mesuré dans une plage de mesure comprenant l'au moins une fréquence au niveau de la batterie (6) en tant que deuxième grandeur électrique.

3. Procédé selon la revendication 1 ou 2,
**caractérisé en ce**
**qu'**un schéma des connexions de remplacement comprenant une résistance d'électrolyte (17) et/ou une résistance de transfert de charge (15) et/ou une impédance de Warburg et/ou une capacité de double couche en tant que composante est utilisé.

4. Procédé selon l'une quelconque des revendications précédentes,
**caractérisé en ce**
**qu'**un convertisseur CC-CC (3), lequel couple le réseau de bord (2) à un autre réseau de bord (4), en particulier à un réseau de bord haute tension pour l'alimentation d'un moteur électrique du véhicule à moteur (1) ou à un réseau de bord basse tension à tension de service supérieure à une tension nominale de la batterie (6), est utilisé.

5. Procédé selon l'une quelconque des revendications précédentes,
**caractérisé en ce**
**que** le procédé est réalisé sur demande d'un système de gestion d'énergie du véhicule à moteur (1) et/ou cycliquement et/ou lors d'un démarrage du véhicule à moteur (1).

6. Véhicule à moteur (1), comprenant une batterie (6) d'un réseau de bord (2) relié à un convertisseur CC-CC (3),
**caractérisé en ce**
**que** le véhicule à moteur (1) présente en plus un appareil de commande (5) réalisé pour la réalisation d'un procédé selon l'une quelconque des revendications précédentes.
